# EUROPEAN PATENT APPLICATION

(11) **EP 4 582 873 A2**
(43) Date of publication of application: **09.07.2025**
(21) Application number: 24218015.6
(22) Date of filing: 06.12.2024
(51) Int. Cl.: G03F 7/038, G03F 7/30

(54) **UV LIGHT SENSITIVE SOLUBILITY MATERIAL FILTRATION**

(30) Priority: 03.01.2024 US 202418402982
(71) Applicant: Goodrich Lighting Systems, Inc., Phoenix, AZ 85040 (US)
(72) Inventor: VASQUEZ, Jose O., Cedar Rapids, IA 52405 (US); WESTERGREN, David L., Cedar Rapids, IA 52402 (US); NANCE, Timothy J., Cedar Rapids, IA 52405-3443 (US)
(74) Representative: Dehns

(57) **Abstract**

A system for filtering a precipitate from a chemical solvent is disclosed herein. The system includes a first pipe segment configured to transport a chemical solvent having a composition dissolved therein, a first ultraviolet light (208, 308, 408) disposed adjacent the first pipe segment and configured to irradiate the chemical solvent and the composition inside the first pipe segment, wherein the composition precipitates from the chemical solvent forming a plurality of particles in response to the first ultraviolet light (208, 308, 408), a first filter (204, 304, 404) having a first inlet and a first outlet and configured to remove a first portion of the plurality of particles from the chemical solvent, wherein the first inlet is coupled to the first pipe segment, and a second pipe segment coupled to the first outlet and configured to transport the chemical solvent.

## Description

### FIELD

The present disclosure generally relates material filtration and more particularly to material filtration of ultraviolet light sensitive materials.

### BACKGROUND

Manufacturing processes, such as photolithography, use photoresist and ultraviolet (UV) light for applying a physical mask to a substrate. Typically, the photoresist is applied to the substrate and exposed to the UV light through a mask. The UV light causes a negative photoresist to polymerize, making the exposed portions of the photoresist insoluble to a developer. A developer is applied to substrate to dissolve the unexposed negative photoresist and remove the negative photoresist from the substrate.

### SUMMARY

A system is disclosed herein. The system includes a first pipe segment configured to transport a chemical solvent having a composition dissolved therein, a first ultraviolet light disposed adjacent the first pipe segment and configured to irradiate the chemical solvent and the composition inside the first pipe segment, wherein the composition precipitates from the chemical solvent forming a plurality of particles in response to the first ultraviolet light, a first filter having a first inlet and a first outlet and configured to remove a first portion of the plurality of particles from the chemical solvent, wherein the first inlet is coupled to the first pipe segment, and a second pipe segment coupled to the first outlet and configured to transport the chemical solvent.

In various embodiments, the second pipe segment has a first end and a second end, the first end being coupled to the first outlet and the system further includes a third pipe segment having a first end and a second end, the second pipe segment configured to transport the chemical solvent, the first end being coupled to the first outlet of the first filter and a second filter having a second inlet and a second outlet and configured to filter the plurality of particles from the chemical solvent, wherein the second inlet is coupled to the first end of the second pipe segment. In various embodiments, the first filter is configured to remove the first portion of the plurality of particles having a first size, wherein the second filter is configured to remove a second portion of the plurality of particles having a second size, and wherein the first size is larger than the second size.

In various embodiments, the system further includes a second ultraviolet light disposed between the first filter and the second filter and configured to irradiate the chemical solvent and the composition inside the second pipe segment. In various embodiments, the composition is a negative photoresist and the negative photoresist crosslinks in response to exposure to the first ultraviolet light. In various embodiments, the chemical solvent has a first saturation of the composition before the first filter and the chemical solvent has a second saturation of the composition after the first filter.

In various embodiments, the first ultraviolet light circumferentially surrounds the first pipe segment. In various embodiments, the first pipe segment is configured to coil around the first ultraviolet light. In various embodiments, the first pipe segment is translucent.

Also disclosed herein is a system for filtering a precipitate from a chemical solvent. The system includes a first pipe segment having a first end and a second end and configured to transport the chemical solvent, a second pipe segment having a first end and a second end and configured to transport the chemical solvent, a third pipe segment having a first end and a second end and configured to transport the chemical solvent, a first filter having a first inlet and a first outlet and configured to remove the precipitate from the chemical solvent, the first inlet coupled to the second end of the first pipe segment, and the first outlet coupled to the first end of the second pipe segment, a second filter having a second inlet and a second outlet and configured to remove the precipitate from the chemical solvent, the second inlet coupled to the second end of the second pipe segment, and the second outlet coupled to the first end of the third pipe segment, and a first ultraviolet light disposed adjacent the first pipe segment and configured to irradiate the chemical solvent, wherein the precipitate forms in response to the first ultraviolet light.

In various embodiments, the system further includes a second ultraviolet light disposed adjacent the second pipe segment and between the first filter and the second filter, the second ultraviolet light configured to irradiate the chemical solvent, wherein the precipitate forms in response to the second ultraviolet light. In various embodiments, the first filter removes the precipitate having a first size and the second filter removes the precipitate having a second size, wherein the first size is larger than the second size. In various embodiments, the first ultraviolet light circumferentially surrounds the first pipe segment.

In various embodiments, the first pipe segment coils around the first ultraviolet light. In various embodiments, the chemical solvent includes dissolved negative photoresist and the precipitate is polymerized negative photoresist, the negative photoresist polymerizing in response to exposure to the first ultraviolet light. In various embodiments, the chemical solvent in the first pipe segment has a first saturation level and the chemical solvent in the third pipe segment has a second saturation level, the second saturation level being less than the first saturation level. In various embodiments, the first pipe segment has a first opacity and the second pipe segment has a second opacity.

Also disclosed herein is a system for filtering a negative photoresist from a chemical solvent. The system includes a first pipe segment having a first end and a second end and configured to transport the chemical solvent, a second pipe segment having a first end and a second end and configured to transport the chemical solvent, a third pipe segment having a first end and a second end and configured to transport the chemical solvent, a first ultraviolet light disposed adjacent the first pipe segment and configured to irradiate the chemical solvent, wherein a precipitate including the negative photoresist forms in response to the first ultraviolet light, a second ultraviolet light disposed adjacent the second pipe segment and configured to irradiate the chemical solvent, wherein the precipitate including the negative photoresist forms in response to the second ultraviolet light, a first filter having a first inlet and a first outlet and configured to remove the precipitate from the chemical solvent, the first inlet coupled to the second end of the first pipe segment, and the first outlet coupled to the first end of the second pipe segment, and a second filter having a second inlet and a second outlet and configured to remove the precipitate from the chemical solvent, the second inlet coupled to the second end of the second pipe segment, and the second outlet coupled to the first end of the third pipe segment.

In various embodiments, the first ultraviolet light circumferentially surrounds the first pipe segment. In various embodiments, the first pipe segment coils around the first ultraviolet light.

The foregoing features and elements may be combined in any combination, without exclusivity, unless expressly indicated herein otherwise. These features and elements as well as the operation of the disclosed embodiments will become more apparent in light of the following description and accompanying drawings.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the following detailed description and claims in connection with the following drawings. While the drawings illustrate various embodiments employing the principles described herein, the drawings do not limit the scope of the claims.
FIGS. 1A, 1B, and 1C illustrate a manufacturing process including a photolithography process, in accordance with various embodiments.
FIG. 2 illustrates a filtration system for removing dissolved negative photoresist from a chemical solvent, in accordance with various embodiments.
FIG. 3 illustrates a filtration system for removing dissolved negative photoresist from a chemical solvent, in accordance with various embodiments.
FIG. 4 illustrates a filtration system for removing dissolved negative photoresist from a chemical solvent, in accordance with various embodiments.

### DETAILED DESCRIPTION

The following detailed description of various embodiments herein makes reference to the accompanying drawings, which show various embodiments by way of illustration. While these various embodiments are described in sufficient detail to enable those skilled in the art to practice the disclosure, it should be understood that other embodiments may be realized and that changes may be made without departing from the scope of the disclosure. Thus, the detailed description herein is presented for purposes of illustration only and not of limitation. While these exemplary embodiments are described in sufficient detail to enable those skilled in the art to practice the invention, it should be understood that other embodiments may be realized and that logical, chemical and mechanical changes may be made without departing from the spirit and scope of the invention. For example, the steps recited in any of the method or process descriptions may be executed in any order and are not necessarily limited to the order presented. Furthermore, any reference to singular includes plural embodiments, and any reference to more than one component or step may include a singular embodiment or step. Also, any reference to attached, fixed, connected, or the like may include permanent, removable, temporary, partial, full or any other possible attachment option. Additionally, any reference to without contact (or similar phrases) may also include reduced contact or minimal contact. It should also be understood that unless specifically stated otherwise, references to "a," "an" or "the" may include one or more than one and that reference to an item in the singular may also include the item in the plural. Further, all ranges may include upper and lower values and all ranges and ratio limits disclosed herein may be combined.

Photolithography processes deposit a negative photoresist material on a substrate, expose the negative photoresist material to UV light through a mask to polymerize the exposed negative photoresist, and remove the unexposed negative photoresist using a solvent chemistry, such as a developer solution. In various embodiments, the solvent chemistry may be reused for multiple developing cycles. In various embodiments, after multiple uses, the negative photoresist dissolved in the solvent chemistry tends to congeal into a gel like state. In various embodiments, the solvent chemistry tends to become less concentrated and less effective due to the congealed negative photoresist. In various embodiments, the congealed negative photoresist may introduce foreign object debris on a substrate during reuse of the solvent chemistry.

Disclosed herein are systems and processes for filtering an ultraviolet (UV) light sensitive material from a solution. In various embodiments, the filtration system includes pipes for transporting the chemical solvent that have a low opacity. In various embodiments, the pipes may feed into one or more filters that are configured to filter out the negative photoresist. In various embodiments, one or more UV lights may be placed adjacent the pipes to induce crosslinking, or polymerization, of the negative photoresist to be filtered by the one or more filters. In various embodiments, the crosslinking precipitates the negative photoresist from the solvent chemistry to be captured by the one or more filters.

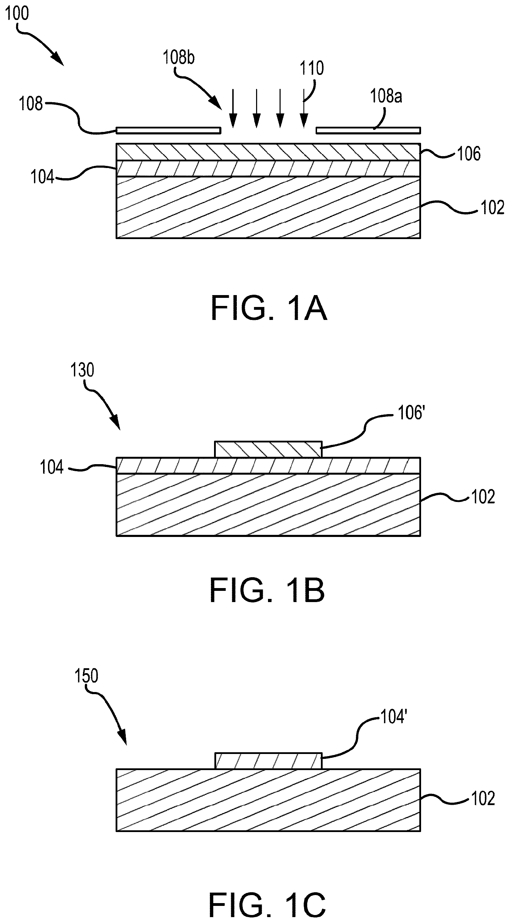

Referring now to FIGS. 1A-1C, a manufacturing process including a photolithography process is illustrated, in accordance with various embodiments. FIG. 1A illustrates a first step 100 of the manufacturing process, including a photolithography process, FIG. 1B illustrates a second step 130 of the manufacturing process, including the photolithography process, and FIG. 1C illustrates a third step 150 of the manufacturing process. At first step 100 includes a substrate 102 and a first layer 104 deposited on substrate 102. A negative photoresist 106 is deposited on first layer 104. A mask 108 including a pattern is placed over negative photoresist 106. As illustrated in FIG. 1A, mask 108 includes a solid, or opaque, portion 108a and an opening 108b through which an ultraviolet (UV) light 110 passes. UV light 110 polymerizes, or hardens, negative photoresist 106.

At second step 130, a chemical solvent, also referred to as a developer, is applied to negative photoresist 106 to form a mask layer 106'. The chemical solvent dissolves and removes the portions of negative photoresist 106 that were not exposed to UV light 110, thereby forming mask layer 106'. In various embodiments, the chemical solvent, including the dissolved negative photoresist 106 may be reused multiple times. With each reuse, more negative photoresist 106 is dissolved into the chemical solvent. Over time, the negative photoresist 106 tends to congeal into a viscous, gel-like state, causing the chemical solvent to thicken. The chemical solvent becomes less concentrated and, in various embodiments, less effective at dissolving and removing unexposed negative photoresist 106. In various embodiments, the chemical solvent may introduce foreign object debris onto first layer 104 and/or substrate 102 causing failed parts and/or other unexpected results. Due to the dissolved negative photoresist 106 the chemical solvent needs to be replaced frequently resulting in lost time and higher expenses.

At third step 150, first layer 104 is etched to form a structure 104' on substrate 102. In various manufacturing processes, the structure 104' may be the final step. In various manufacturing processes, the process described above may be repeated many times. It will be appreciated that this is a simplified description of a photolithography process and is for description purposes and is not intended to be limiting.

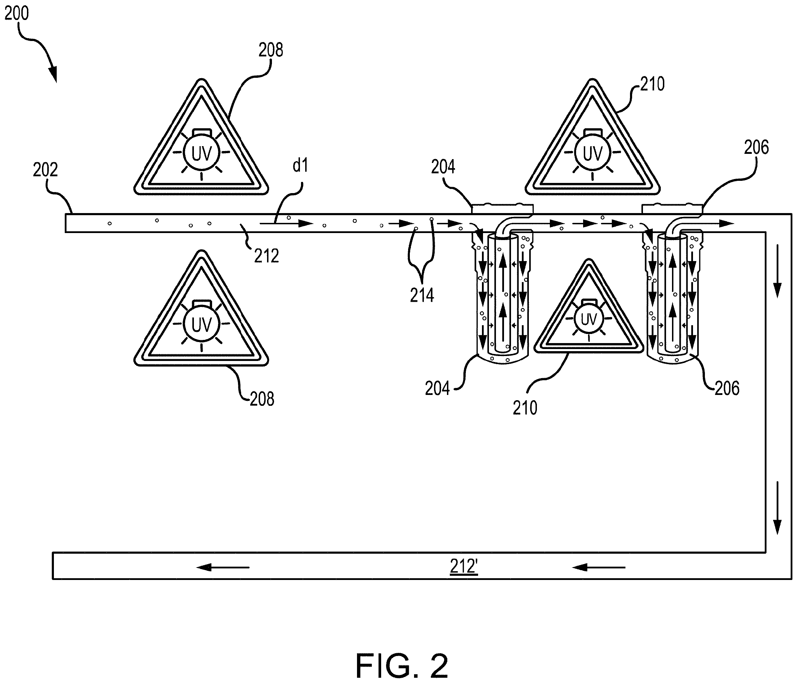

Referring now to FIG. 2, a filtration system 200 is illustrated, in accordance with various embodiments. Filtration system 200 includes a pipe 202, a first filter 204, a second filter 206, a first ultraviolet (UV) light 208, a second UV light 210, and a chemical solvent 212. Pipe 202 is configured to contain and move chemical solvent 212 past first UV light 208, through first filter 204, past second UV light 210, and through second filter 206. In various embodiments, pipe 202 may include a plurality of pipes including a first pipe coupled to a first end of first filter 204, a second pipe coupled to a second end of first filter 204 and coupled to a first send of second filter 206, and a third pipe coupled to a second end of second filter 206, among others.

In various embodiments, pipe 202 may be transparent. In various embodiments, pipe 202 may be translucent. As described herein, transparent may be about 0% to about 20% opacity, translucent may be about 20% to about 95% opacity, and opaque may be about 95% to about 100% opacity. In various embodiments, pipe 202 may have an opacity of 0% to about 75%, and more specifically, an opacity of about 5% to about 50%. In various embodiments, pipe 202 may have a first opacity for UV light and second opacity for visible light. Materials may block different types of light so that a material may block more visible light than UV light or block more UV light than visible light. In other works, the material (e.g., pipe 202) may have an opacity of 50% for visible light and an opacity of 25% for UV light. In various embodiments, the first opacity may be about equal to the second opacity. In various embodiments, the first opacity may be less than the second opacity, tending to allow UV light to pass while blocking some visible light. In various embodiments, the first opacity may be greater than the second opacity, tending to allow visible light to pass while blocking some UV light.

First filter 204 and second filter 206 may, in various embodiments, each include one or more filters. In various embodiments, first filter 204 and/or second filter 206 may be a mesh screen filter configured to remove particles 214 from chemical solvent 212. First filter 204 is configured to remove particles 214 having a first size from chemical solvent 212. Second filter 206 is configured to remove particles 214 having a second size from chemical solvent 212. In various embodiments, the first size and the second size may be about 0.1 nm to about 500 nm, and more specifically, about 1 nm to about 250 nm. In various embodiments, particles 214 may be up to 10 microns in size. Accordingly, first filter 204 and second filter 206 are configured to remove the largest particles before they affect the performance of system 200. Typically, particles 214 are not uniform in size as they cross-link and grow in size.

First filter 204 and second filter 206 are configured to keep the saturation of the negative photoresist below threshold in order to maintain a consistent performance of the system, and specifically, the chemical solvent. In various embodiments, the second size may be about the same as the first size. In various embodiments, the second size may be smaller than the first size. Various configurations allow for a stepped down filtering process to reduce the potential of clogging first filter 204 and/or second filter 206. That is, first filter 204 removes larger particles and second filter 206 removes smaller particles.

First UV light 208 and second UV light 210 are configured to irradiate the pipe 202, and more specifically, chemical solvent 212 flowing inside pipe 202. Specifically, first UV light 208 and second UV light 210 are configured to produce particles 214 from chemical solvent 212 including dissolved negative photoresist. The dissolved negative photoresist cross-links, or polymerizes, in response to being exposed to UV lights 208, 210. The cross-linked negative photoresist precipitates from the solvent chemistry, forming particles 214. That is, the dissolved negative photoresist solidifies in response to being exposed to UV lights 208, 210 and falls out of, or un-dissolves from, chemical solvent 212. Particles 214 are then removed from chemical solvent 212 by filters 204, 206. In various embodiments, first UV light 208 may include one or more UV lights. In various embodiments, second UV light 210 may include one or more UV lights.

First UV light 208 operates at a first wavelength and second UV light 208 operates at a second wavelength. In various embodiments, first wavelength is about equal to second wavelength. In various embodiments, first wavelength is greater than second wavelength. In various embodiments, first wavelength is less than second wavelength. In various embodiments, first wavelength may be about 200 nm to about 500 nm, and more specifically, about 300 nm to about 400 nm. In various embodiments, second wavelength may be about 200 nm to about 500 nm, and more specifically, about 300 nm to about 400 nm. First and second wavelength may be modified to work with the type of negative photoresist being used.

First UV light 208 produces a first power and second UV light 210 produces a second power. In various embodiments, first power may be about equal to second power. In various embodiments, first power may be greater than second power. In various embodiments, first power may be less than second power. In various embodiments, first power may be about 1 mW/cm² to about 1,000 mW/cm², and more specifically, about 50 mW/cm² to about 500 mW/cm². In various embodiments, second power may be about 1 mW/cm² to about 1,000 mW/cm², and more specifically, about 50 mW/cm² to about 500 mW/cm². First and second power may be modified to work with the type of negative photoresist being used. For example, in various embodiments, the negative photoresist may be sensitive to 1.25 mW/cm² at a 365 nm wavelength. Additionally, first and second power may be modified based on the opacity of pipe 202 to improve absorption of the UV light by the dissolved negative photoresist. For example, a lower power may be used when pipe 202 has a lower opacity and a higher power may be used when pipe 202 has a higher opacity. First and second power may be modified based on the flow rate of chemical solvent 212 within pipe 202. A higher power may be used for a faster flow rate and a lower power may be used for a slower flow rate.

As illustrated in FIG. 2, chemical solvent 212 including a first saturation of dissolved negative photoresist flows in a first direction d1 inside pipe 202. Chemical solvent 212 is exposed to UV light through pipe 202 by first UV light 208. A portion of the negative photoresist cross-links in response to being exposed to the UV light, the cross-linked negative photoresist precipitates out of chemical solvent 212 forming particles 214, thereby decreasing the saturation of dissolved negative photoresist in chemical solvent 212. First filter 204 removes particles 214 from chemical solvent 212 that are larger than the first size. Chemical solvent 212 is exposed to UV light through pipe 202 by second UV light 210. A portion of the negative photoresist cross-links in response to being exposed to the UV light, forming more particles 214, and further lower the saturation of dissolved negative photoresist in chemical solvent 212. Second filter 206 removes particles 214 larger than the second size from chemical solvent 212 so that a chemical solvent 212' exiting second filter 206 has a second saturation of the negative photoresist and little to no particles 214 bigger than the second size. The second saturation is below a predefined threshold for chemical solvent 212' to be effectively used.

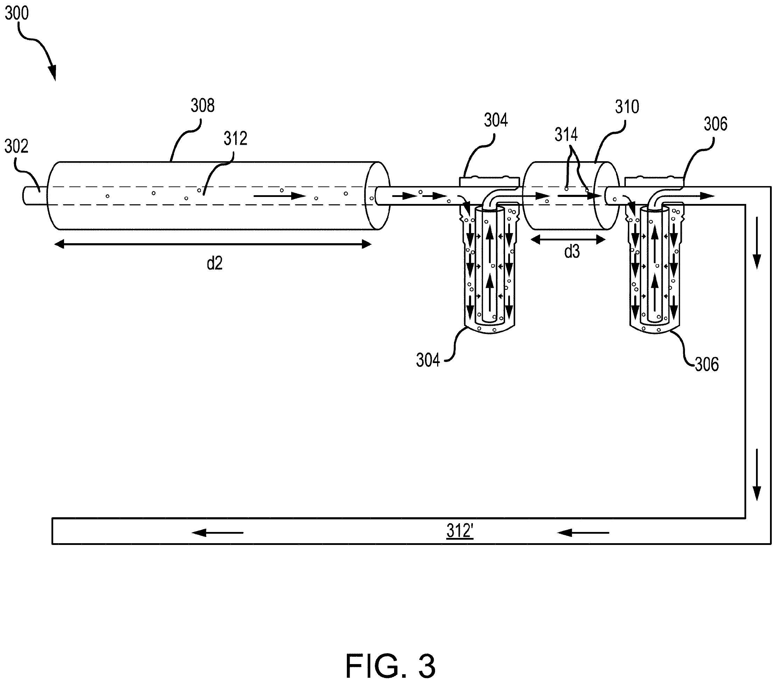

Referring now to FIG. 3, a filtration system 300 is illustrated, in accordance with various embodiments. Filtration system 300 includes similar components to those described above with respect to filtration system 200 in FIG. 2, including a pipe 302, a first filter 304, a second filter 306, and a chemical solvent 312, descriptions of which will not be repeated below. Filtration system 300 further includes a first ultraviolet (UV) light 308, a second UV light 310. Functionally, first UV light 308 and second UV light 310 are similar to first UV light 208 and second UV light 210 described above in FIG. 2 with respect to filtration system 200, similar descriptions will not be repeated below.

First UV light 308 is configured to circumferentially surround pipe 302 for a first length d2 of pipe 302. Second UV light 310 is configured to circumferentially surround pipe 302 for a second length d3 of pipe 302. In various embodiments, first length d2 may be about equal to second length d3. In various embodiments, first length d2 may be greater than second length d3 (as illustrated in FIG. 3). In various embodiments, first length d2 may be less than second length d3. Circumferentially surrounding pipe 302 tends to increase the amount of power per volume delivered to chemical solvent 312 by first UV light 308 and/or second UV light 310. In various embodiments, first UV light 308 and/or second UV light 310 may output a lower intensity UV light with little to no decrease in the amount of power received by chemical solvent 312 by circumferentially surrounding pipe 302. That is, the intensity, or power per unit area, may be lower but the distribution is better due to UV light 308, 310 surrounding pipe 202 and exposing a larger unit area, or volume, within pipe 202 to the UV light.

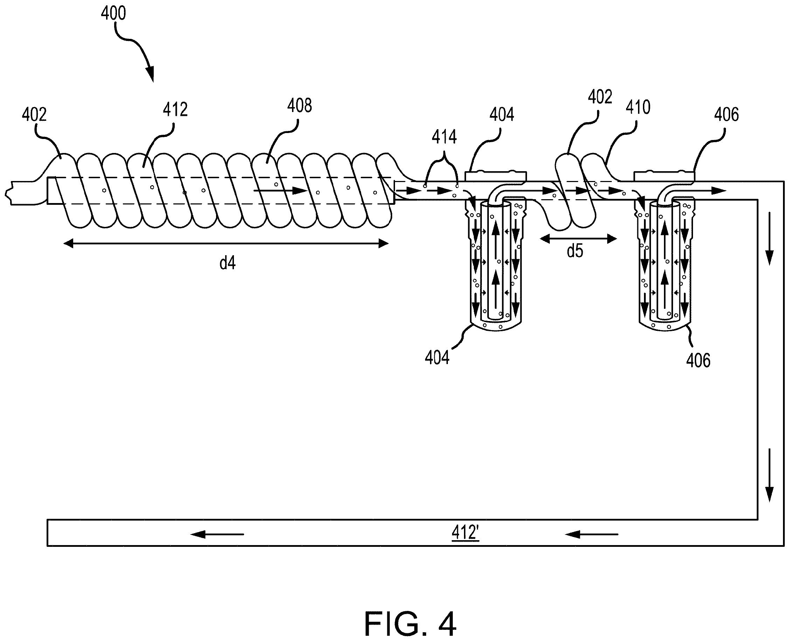

Referring now to FIG. 4, a filtration system 400 is illustrated, in accordance with various embodiments. Filtration system 400 includes similar components to those described above with respect to filtration system 200 in FIG. 2, including a first filter 404, a second filter 406, and a chemical solvent 412, descriptions of which will not be repeated below. Filtration system 400 further includes a pipe 402, a first ultraviolet (UV) light 408, a second UV light 410. Functionally, pipe 402, first UV light 408, and second UV light 410 are similar to pipe 202, first UV light 208, and second UV light 210 described above in FIG. 2 with respect to filtration system 200, similar descriptions will not be repeated below.

As illustrated in FIG. 4, pipe 402 is configured to coil around first UV light 408 and second UV light 410. That is, pipe 402 wraps circumferentially around first UV light 408 and second VU light 410. Pipe 402 coiling around first UV light 408 and second UV light 410 tends to expose different portions of chemical solvent 412 to the UV light. Pipe 402 has a first number of coils around first UV light 408 and a second number of coils around second UV light 410. In various embodiments, the first number of coils may be about 2 to about 25, or more. In various embodiments, the second number of coils may be about 2 to about 25 coils, or more. In various embodiment, the first number of coils may be greater than the second number of coils. In various embodiment, the first number of coils may be about equal to the second number of coils. In various embodiment, the first number of coils may be less than the second number of coils.

Benefits, other advantages, and solutions to problems have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the disclosure. The scope of the disclosure is accordingly to be limited by nothing other than the appended claims, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, Band C may be present in a single embodiment; for example, A and B, A and C, B and C, or A and B and C. Different cross-hatching is used throughout the figures to denote different parts but not necessarily to denote the same or different materials.

Systems, methods, and apparatus are provided herein. In the detailed description herein, references to "one embodiment," "an embodiment," "various embodiments," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

Numbers, percentages, or other values stated herein are intended to include that value, and also other values that are about or approximately equal to the stated value, as would be appreciated by one of ordinary skill in the art encompassed by various embodiments of the present disclosure. A stated value should therefore be interpreted broadly enough to encompass values that are at least close enough to the stated value to perform a desired function or achieve a desired result. The stated values include at least the variation to be expected in a suitable industrial process, and may include values that are within 5%of a stated value. Additionally, the terms "substantially," "about" or "approximately" as used herein represent an amount close to the stated amount that still performs a desired function or achieves a desired result. For example, the term "substantially," "about" or "approximately" may refer to an amount that is within 5% of a stated amount or value.

Furthermore, no element, component, or method step in the present disclosure is intended to be dedicated to the public regardless of whether the element, component, or method step is explicitly recited in the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

Finally, it should be understood that any of the above-described concepts can be used alone or in combination with any or all of the other above-described concepts. Although various embodiments have been disclosed and described, one of ordinary skill in this art would recognize that certain modifications would come within the scope of this disclosure. Accordingly, the description is not intended to be exhaustive or to limit the principles described or illustrated herein to any precise form. Many modifications and variations are possible in light of the above teaching.

## Claims

1. A system, comprising:
a first pipe segment configured to transport a chemical solvent having a composition dissolved therein;
a first ultraviolet light (208, 308, 408) disposed adjacent the first pipe segment and configured to irradiate the chemical solvent and the composition inside the first pipe segment, wherein the composition precipitates from the chemical solvent forming a plurality of particles in response to the first ultraviolet light;
a first filter (204, 304, 404) having a first inlet and a first outlet and configured to remove a first portion of the plurality of particles from the chemical solvent, wherein the first inlet is coupled to the first pipe segment; and
a second pipe segment coupled to the first outlet and configured to transport the chemical solvent.

2. The system of claim 1, wherein the second pipe segment has a first end and a second end, the first end being coupled to the first outlet, the system further comprising:
a third pipe segment having a first end and a second end, the second pipe segment configured to transport the chemical solvent, the first end being coupled to the first outlet of the first filter; and
a second filter (206, 306, 406) having a second inlet and a second outlet and configured to filter the plurality of particles from the chemical solvent, wherein the second inlet is coupled to the first end of the second pipe segment.

3. The system of claim 2, wherein the first filter (204, 304, 404) is configured to remove the first portion of the plurality of particles having a first size, wherein the second filter (206, 306, 406) is configured to remove a second portion of the plurality of particles having a second size, and wherein the first size is larger than the second size.

4. The system of claim 2, further comprising:
a second ultraviolet light (210, 310, 410) disposed between the first filter and the second filter and configured to irradiate the chemical solvent and the composition inside the second pipe segment.

5. The system of any preceding claim, wherein the composition is a negative photoresist and the negative photoresist crosslinks in response to exposure to the first ultraviolet light.

6. The system of any preceding claim, wherein the chemical solvent has a first saturation of the composition before the first filter and the chemical solvent has a second saturation of the composition after the first filter.

7. The system of any preceding claim, wherein the first ultraviolet light (208, 308, 408) circumferentially surrounds the first pipe segment.

8. The system of any preceding claim, wherein the first pipe segment is configured to coil around the first ultraviolet light (208, 308, 408); and/or wherein the first pipe segment is translucent.

9. A system for filtering a precipitate from a chemical solvent, the system comprising:
a first pipe segment having a first end and a second end and configured to transport the chemical solvent;
a second pipe segment having a first end and a second end and configured to transport the chemical solvent;
a third pipe segment having a first end and a second end and configured to transport the chemical solvent;
a first filter (204, 304, 404) having a first inlet and a first outlet and configured to remove the precipitate from the chemical solvent, the first inlet coupled to the second end of the first pipe segment, and the first outlet coupled to the first end of the second pipe segment;
a second filter (206, 306, 406) having a second inlet and a second outlet and configured to remove the precipitate from the chemical solvent, the second inlet coupled to the second end of the second pipe segment, and the second outlet coupled to the first end of the third pipe segment; and
a first ultraviolet light (208, 308, 408) disposed adjacent the first pipe segment and configured to irradiate the chemical solvent, wherein the precipitate forms in response to the first ultraviolet light (208, 308, 408).

10. The system of claim 9, further comprising:
a second ultraviolet light (210, 310, 410) disposed adjacent the second pipe segment and between the first filter (204, 304, 404) and the second filter (206, 306, 406), the second ultraviolet light (210, 310, 410) configured to irradiate the chemical solvent, wherein the precipitate forms in response to the second ultraviolet light (210, 310, 410).

11. The system of claim 9 or 10, wherein the first filter (204, 304, 404) removes the precipitate having a first size and the second filter (206, 306, 406) removes the precipitate having a second size, wherein the first size is larger than the second size; and/or wherein the first ultraviolet light (208, 308, 408) circumferentially surrounds the first pipe segment.

12. The system of claim 9, 10 or 11, wherein the first pipe segment coils around the first ultraviolet light (208, 308, 408); and/or wherein the first pipe segment has a first opacity and the second pipe segment has a second opacity.

13. The system of claim 9, 10, 11 or 12, wherein the chemical solvent includes dissolved negative photoresist and the precipitate is polymerized negative photoresist, the negative photoresist polymerizing in response to exposure to the first ultraviolet light (208, 308, 408); and/or wherein the chemical solvent in the first pipe segment has a first saturation level and the chemical solvent in the third pipe segment has a second saturation level, the second saturation level being less than the first saturation level.

14. A system for filtering a negative photoresist from a chemical solvent, the system comprising:
a first pipe segment having a first end and a second end and configured to transport the chemical solvent;
a second pipe segment having a first end and a second end and configured to transport the chemical solvent;
a third pipe segment having a first end and a second end and configured to transport the chemical solvent;
a first ultraviolet light (208, 308, 408) disposed adjacent the first pipe segment and configured to irradiate the chemical solvent, wherein a precipitate including the negative photoresist forms in response to the first ultraviolet light (208, 308, 408);
a second ultraviolet light (210, 310, 410) disposed adjacent the second pipe segment and configured to irradiate the chemical solvent, wherein the precipitate including the negative photoresist forms in response to the second ultraviolet light (210, 310, 410);
a first filter (204, 304, 404) having a first inlet and a first outlet and configured to remove the precipitate from the chemical solvent, the first inlet coupled to the second end of the first pipe segment, and the first outlet coupled to the first end of the second pipe segment; and
a second filter (206, 306, 406) having a second inlet and a second outlet and configured to remove the precipitate from the chemical solvent, the second inlet coupled to the second end of the second pipe segment, and the second outlet coupled to the first end of the third pipe segment.

15. The system of claim 14, wherein the first ultraviolet light (208, 308, 408) circumferentially surrounds the first pipe segment; and/or wherein the first pipe segment coils around the first ultraviolet light (208, 308, 408).
